# EUROPÄISCHE PATENTSCHRIFT

(11) **EP 0 719 454 B1**
(45) Veröffentlichungstag und Bekanntmachung des Hinweises auf die Patenterteilung: **12.05.2004**
(21) Anmeldenummer: 94926783.5
(22) Anmeldetag: 15.09.1994
(51) Int. Cl.: H01L 27/146, H01L 31/112, H01L 31/113

(54) **HALBLEITER(DETEKTOR)STRUKTUR**
SEMICONDUCTOR (DETECTOR) STRUCTURE
STRUCTURE (DE DETECTEUR) A SEMI-CONDUCTEURS

(30) Priorität: 15.09.1993 DE 4331391
(43) Veröffentlichungstag der Anmeldung: 03.07.1996
(73) Patentinhaber: Max-Planck-Gesellschaft zur Förderung der Wissenschaften e.V., 80539 München (DE); KEMMER, Josef, Dr., D-85764 Oberschleissheim (DE)
(72) Erfinder: KEMMER, Josef, D-85764 Oberschleissheim (DE); LUTZ, Gerhard, D-81739 München (DE); RICHTER, Rainer, D-81243 München (DE); EHWALD, Karl-Ernst, D-15232 Frankfurt/Oder (DE)
(74) Vertreter: Popp, Eugen, Dr.
(86) Internationale Anmeldenummer: PCT/DE1994/001066
(87) Internationale Veröffentlichungsnummer: WO 1995/008190

(56) Entgegenhaltungen:
- EP-A- 0 042 218
- EP-A- 0 094 974
- DE-A- 2 952 413
- DE-A- 3 345 190
- FR-A- 2 563 657
- GB-A- 1 444 541

## Beschreibung

### Technisches Gebiet

In der Patentanmeldung wird eine Halbleiterstruktur vorgeschlagen, die sowohl Detektor- als auch Verstärkereigenschaften besitzt. Solche Strukturen sind aus früheren Patentanmeldungen (1) als auch aus der Literatur (2) bekannt. Sie eignen sich als eigenständiger Detektor, als integrierte Auslesestruktur anderer Halbleiterdetektoren wie z.B. Driftkammern (3), Drift-Dioden (4) oder CCDs (5) und insbesondere als Grundelement von Bildzellen-Detektoren (6).

### Stand der Technik

In allen diesen Anwendungen erfolgt das Auslesen durch Vergleich des Stromflusses des Unipolartransistors mit und ohne Signalladung, die in einem Potentialminimum (Maximum für negative Ladung) unterhalb des Transistorkanals, dem "internen" Gate, gesammelt wird. Das Rücksetzen des Systems (Löschen der Signalladung) erfolgt entweder durch Anlegen eines Spannungspulses (positiv für gespeicherte Elektronen) an eine Rücksetz-Elektrode oder durch kontinuierliches \"Uberlaufen des nahezu gefüllten Potentialtopfes.

Ein Problem in der Anwendung dieses Detektorprinzips ergibt sich bei Anordnungen, in denen eine Vielzahl dieser Detektor-Verstärker Strukturen verwendet werden. Dies ist z.B. der Fall bei Bildzellen-Detektoren. Hier möchte man zur Reduzierung des Leistungsverbrauchs die einzelnen Transistoren mit möglichst geringem Ruhestrom betreiben. Da im allgemeinen Schwellenspannungsschwankungen in den individuellen Transistoren auftreten, die Transistoren aber mit gleichen Spannungen betrieben werden, kann der Leistungsverbrauch des Gesamtsystems nicht beliebig klein gemacht werden. Weiterhin können unterschiedlich Ruheströme unterschiedliche Steilheiten und damit auch unterschiedliche Signalverstärkungen sowie "Offsets" zur Folge haben.

Ziel der Erfindung ist es, die Detektor-Verstärkertruktur im Ladungssammlungszustand nahe der Schwelle zu betreiben, so daß der Leistungsverbrauch in diesem Zustand sehr klein ist. Dabei soll sich dieser Zustand selbstständig einstellen, im wesentlichen unabhängig von den angelegten Spannungen, bzw. der Schwellenspannung des Transistors.

### Darstellung der Erfindung

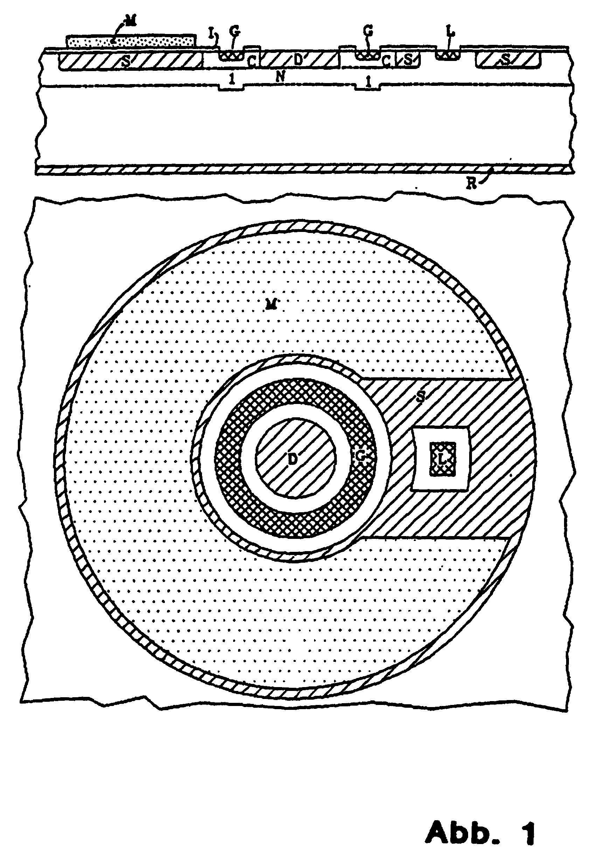

Diese Aufgabe wird erfindungsgemäß dadurch gelöst, daß die Source des Transistors nicht direkt, sondern über eine Kapazität an eine externe Spannung angeschlossen wird. Die Funktionsweise soll anhand einer p-Kanal DEPFET-Struktur erläutert werden. Es sind allerdings auch andere Strukturen denkbar. Die Source ist an den Kondensator angeschlossen, dessen zweite Elektrode auf festem Potential V_{K} (z.B Erdpotential) liegt. Die Kapazität ist in die Struktur integriert. Ein Beispiel, für diese Integration ist in Abb.1 gegeben, in der Querschnitt sowie Aufsicht einer geschlossenen (ringförmigen) Transistorstruktur in einem im wesentlichen vollständig verarmten n-dotierten Halbleiterkörper gezeigt wird. Gate (G) und Source (S) sind deshalb an beiden Seiten der im Zentrum angeordneten Drain (D) zu sehen, eine kleine Rücksetzektrode (L) befindet sich in der Source rechts. Der Rückkontakt (R) dient zur Verarmung des Halbleiterkörpers von Ladungsträgern und zur Ausbildung eines Potentialberges unterhalb der oberen Hauptfläche. Eine groβflächige Verstärkung (N) der n-Dotierung bewirkt gleichzeitig die Ausbildung eines Potentialmaximums (1) zwischen Source und Drain, sowie die Verhinderung von Löcherinjektion aus p-Gebieten der Oberseite zur Unterseite, wenn das Potentialmaximum durch Anlegen einer negativen Spannung an den Rückkontakt (R) nahe an die obere Hauptfläche geschoben wird. Das Potentialmaximum unterhalb des Gates kann durch zusätzliche lokale n-Implantation noch verstärkt werden. Das Implantationsgebiet der Source (links im Bild) dient gleichzeitig als erste Elektrode der Kapazität. Zusammen mit dem Dielektrikum (I) und der darüber befindlichen (metallischen) extern anschließbaren zweiten Elektrode (M) wird die Kapazität Cₛ gebildet. Das Dielektrikum I wird in der Aufsicht nicht gezeigt. Auf ein anderes Beispiel der Integration des Kondensators wird später eingegangen. In der Funktionsbeschreibung wird von einem Ausgangszustand ausgegangen, in dem Drain D auf Erdpotential und das Gate G auf einem festen Potential V_{G} liegen, so daß Source und Drain über den Kanal C miteinander leitend verbunden sind. Der Rückkontakt R ist auf genügend negativem Potential, so daß der n-dotierte Halbleiterkörper im Wesentlichen verarmt ist. Wird nun eine negative Spannung V_{D} an das Drain angelegt, so fließt ein Drainstrom, der zum Erliegen kommt, wenn die Source eine genügend negative Spannung erreicht hat, so daß der Transistor wieder gesperrt ist.

Die Detektor-Verstärker Struktur kann nun in diesem nahezu stromlosen Zustand gehalten werden. Wird nun z.B. durch Einfall ionisierender Strahlung negative Signalladung im Potentialmaximum unter dem Gate gesammelt, so wird der Transistorkanal wieder leitend und sperrt erst wieder bei Erreichung einer entsprechend negativeren Source-Spannung. Die im generierten Strompuls transferierte Ladung entspricht der Signalladung verstärkt um den Faktor ≈ C_{S}/C_{G} wobei C_{G} die Gate-Kanal Kapazität ist. Die verstärkte Signalladung wird in der beschriebenen Weise sofort, z.B. durch Messung des Drainstromes ausgelesen. Sie kann aber auch verzögert ausgelesen werden, wenn das Gate nach Einstellung des Gleichgewichtszustandes zu positiveren Werten hin verschoben wird. Dann bewirkt die zusätzliche Signalladung keinen Stromfluβ. Dieser tritt erst auf, wenn die Gatespannung auf den ursprünglichen Wert zurückgesetzt wird. In einer Anordnung mit vielen Detektor-Verstärker-Strukturen wird damit ein serielles Auslesen ermöglicht, wenn die Gatespannungen zeitlich versetzt verändert werden. Zusätzlich kann dabei das Auslesen durch die Einstellung einer negativeren Gatespannung beschleunigt werden.

Das Löschen der Signalladungen kann nach bereits bekannten Methoden erfolgen, oder aber durch eine neue Struktur, auf die erst später eingegangen wird. Nach dem Löschen der Signalladung ist die Struktur (zumindest für kleinere Signale) unempfindlich. Ein Rücksetzen der Kapazität Cₛ ist erforderlich. Dies kann auf verschiedene Weise erfolgen. Konzeptionell am einfachsten ist eine kurzzeitige Veränderung der Drainspannung V_{D} in positive Richtung bis zu einem Wert, bei welchem die Funktion von Drain und Source vertauscht sind. Damit stellt sich die Sourcespannung wieder auf den ursprünglichen Wert ein. Die dabei fließende Nettoladung entspricht der verstärkten Signalladung und kann daher also auch zu ihrer Bestimmung benutzt werden.

Eine andere Möglichkeit zum Rücksetzen der Source ist die Generation von Elektron-Loch-Paaren in der Region zwischen Source bzw. Kanal und Gate oder einem anderen positiven Kontakt (z.B. Rücksetzkontakt). Dies kann z.B. durch kurzzeitige Beleuchtung erfolgen. Auch stetige langzeitige Beleuchtung oder eine Verringerung der Minoritätsladungsträger-Lebensdauer in Oberflächennähe ist von Interesse. Damit können die Strukturen kontinuierlich nahe der Schwelle bei kleinen Strömen betrieben werden. Um die Generation von Ladungsträgern durch Licht auf bestimmte Gebiete, wie z.B. die unmittelbare Umgebung der Source zu begrenzen, kann eine lichtundurchlässige Schicht auf der Oberseite der Halbleiterstruktur aufgebracht werden, die lokale Öffnungen aufweist.

Verschiedene Rücksetzmethoden für die Signalladung sind in der Literatur beschrieben worden. Meistens wird ein n⁺ Kontakt nahe (oder innerhalb) der Drain oder Source angebracht und durch Anlegen eines positiven Spannungspulses das Potential im Halbleiterkörper so verändert, daß das Potentialmaximum unter dem Gate kurzzeitig verschwindet (oder zumindest verringert wird) und die Signalladung zum Rücksetz-Kontakt abfließt. Auch ein kontinuierlicher langsamer Abluß ist möglich, wenn ein kleiner Rücksetz-Kontakt unsymmetrisch zur Source angebracht ist. Dann fließt die Signalladung nur an einer Stelle entlang der Breite des Kanals (langsam) zum Rücksetzkontakt ab. Alle diese Rücksetz-Strukturen haben den Nachteil, daβ das Potential im Inneren des Halbleiters (die Detektorregion) vom Lösch-Vorgang, oder schon durch die Anwesenheit der Rücksetzelektrode (bei kontinuierlichem Löschen), beeinflußt wird. Da das Potential der Rücksetzelektrode oft positiver als das Potential des internen Gates ist, wird während des Löschvorganges zumindest ein Teil der generierten Signalladung direkt zum Rücksetz-Kontakt abflieβen und für eine spätere Messung nicht mehr zur Verfügung stehen.

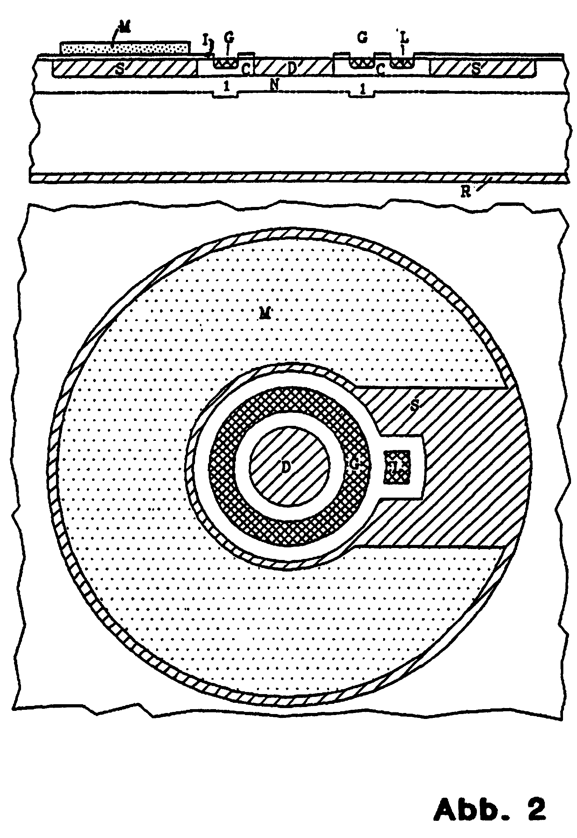

Eine Rücksetz-Struktur, die diese Nachteile vermeidet, ist in Abb. 2 gezeigt. Sie besteht aus einem n⁺-Kontakt (L, der an der Oberfläche in Nähe des Potentialmaximums (1) angebracht ist, in dem die Signalladungen (Elektronen) gesammelt werden. Er ist von den Signalladungen durch den p-dotierten Kanal (C) getrennt. In dem gezeigten Beispiel befindet er sich an einer lokalen Stelle zwischen Source (S) und Gate (G) der im wesentlichen ringförmig ausgebildeten Stuktur. Die Signalladung kann nun durch Anlegen eines positiven Pulses über die durch die Kanalimplantation (C) bewirkte Potentialbarriere hinweg gelöscht werden. Noch interessanter ist aber das kontinuierlich Wegführen durch Wahl einer geeigneten konstanten positiven Spannung am Rücksetz-Kontakt (L).

In den bisher beschriebenen Ausführungsbeispielen wurde die Source der Grundstruktur über jeweils eine Kapazität an ein definiertes Potential gelegt. Es ist aber auch möglich, die Kapazität in mehrere Teilkapazitäten aufzuspalten, die jeweils mit einer anderen (eventuell auf verschiedenem Potential befindlichen) Elektrode verbunden wird. Das verstärkte Signal spaltet sich dann im Verhältnis der Kapazitäten auf und kann mehrmals verarbeitet werden. Dies ist z.B. von Interesse in Bildzellendetektoren, bestehend aus einer Matrix von Grundzellen, in denen Kondensatoren verschiedener Grundelemente über Auswahlleitungen miteinander verbunden werden. Sind mehrere Kondensatoren (z.B. drei) pro Grundzelle vorhanden, so kann man mehrere, in verschiedene (drei) Richtungen verlaufende Auswahlleiungen verwenden. Wird diese Anordnung nun im Schwellenzustand betrieben, so tritt das Signal eines Teilchens an mehreren Auswahlleitungen auf.und eine eindeutige Ortszuordnung ist auch bei mehreren gleichzeitig einfallenden Teilchen möglich.

### Kurze Beschreibung der Zeichnung

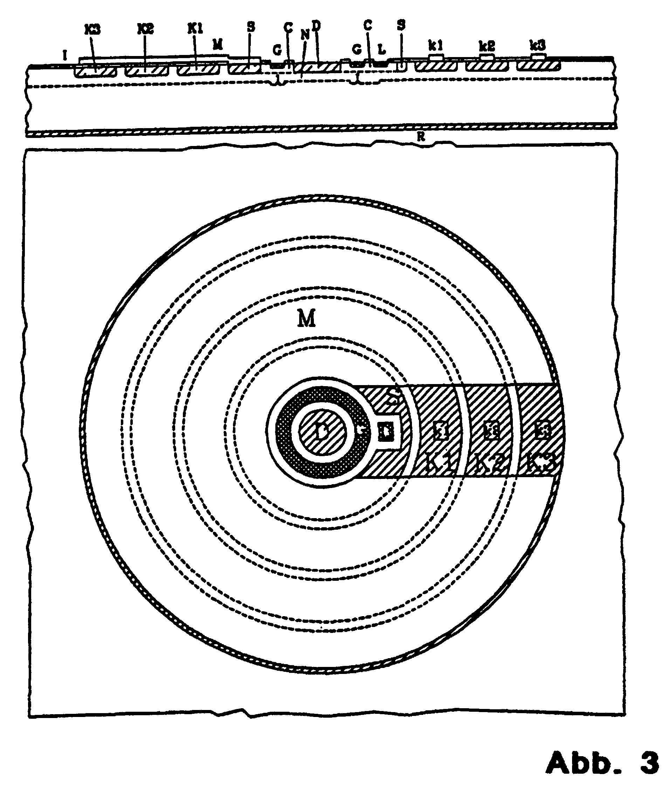

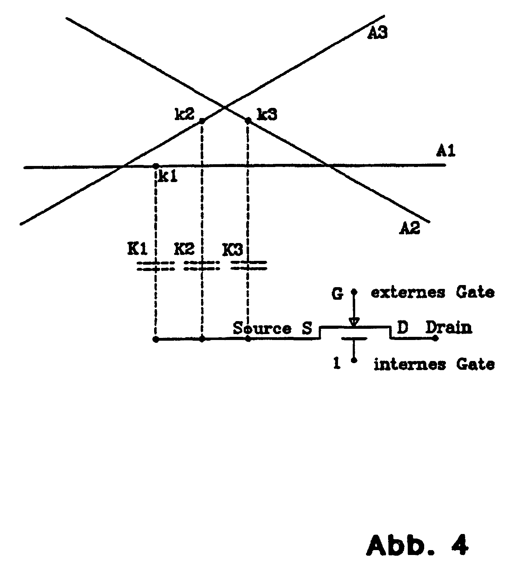

Ein Beispiel für die Grundstruktur einer derartigen Anordnung ist in Abb. 3 gezeigt. Der Querschnitt einer geschlossenen Grundstruktur zeigt links die Ausbildung der den Großteil der Oberfläche einnehmenden Kapazitäten, der rechte Teil die Anschlüsse (k1,k2,k3), für die Auswahlleitungen. Die erste, mit der Source verbundene Elektrode der Kapazitäten ist als Metallelektrode (M) über dem Dielektrikum (I) ausgebildet. Die zweiten, an die Auswahlleitungen angeschlossenen Elektroden der Kapazitäten sind ringförmig ausgebildet, als implantierte Bereiche (K1,K2,K3) im Substrat. Die Knoten k1,k2 und k3 werden durch Kontakte entsprechend dem Ersatzschaltbild (Abb. 4) an in unterschiedliche Richtungen verlaufende Auswahlleitungen (A1,A2,A3) angeschlossen. Durch Anlegen von unterschiedlichen Spannungen an die Auswahlleitungen unterschiedlicher Richtung ist es in dieser Anordnung möglich, ein Driftfeld zu erzeugen, das die Signalelektronen zu den Potentialmaxima unter den Gates hinleitet, und damit die Ladungssammlungszeit verkürzt. Weiterhin ist es in dieser Anordnung, bei der die zweiten Elektroden als Implant im Halbleiter geführt werden, möglich, die Auswahlleiungen verschiedener Richtungen ohne Einführung einer zusätzlichen Verdrahtungsebene zu überkreuzen.

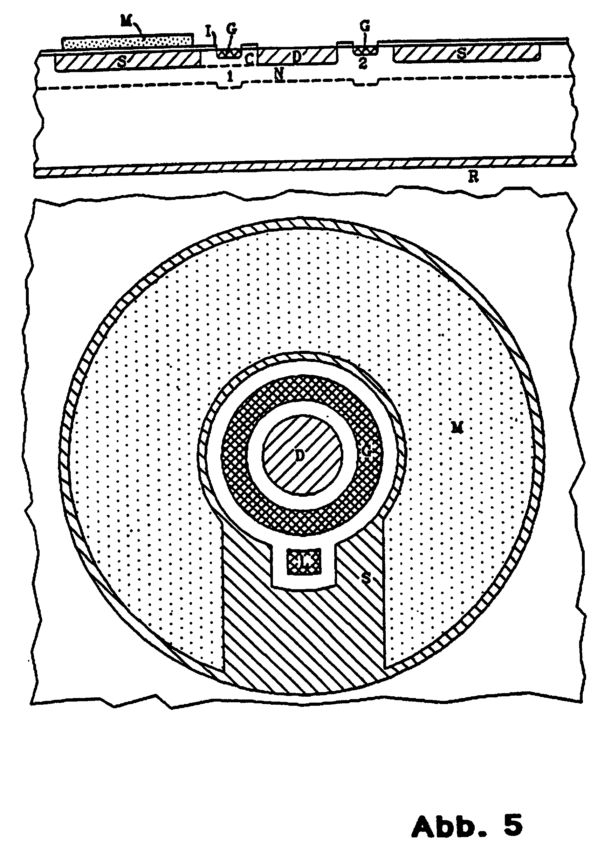

In den bisherigen Ausführungsbeispielen wurde das Topgate (G) an eine externe Spannung angeschlossen. Es ist aber auch möglich das Topgate mit dem internen Gate (1) (teilweise mit Elektronen gefülltes Potentialmaximum) zusammenzuschließen. In dem in Abb. 5 gezeigten Beispiel erfolgt dies durch Weglassen der Kanaldotierung (C) unterhalb eines Teils des Gates (2 rechts im Bild). Das Potential dieses zusammengeschlossenen Gates wird durch den Rücksetzvorgang voreingestellt. Das Löschen der Signalladung kann dabei sowohl kontinuierlich als auch gepulst erfolgen. Ein Vorteil dieser Anordnung ist, daß die Auswahlleitung für das Topgate (G) entfallen kann. Die Löschstruktur für die Signalladung ist im Bild nicht gezeigt. Ein weiterer Vorteil dieser Anordnung ist eine erhöhte Steuerwirkung der Signalladung auf den Kanal, sowie eine Erhöhung der Geschwindigkeit des Signalanstieges, insbesondere beim Betrieb des Transistors nahe der Schwelle.

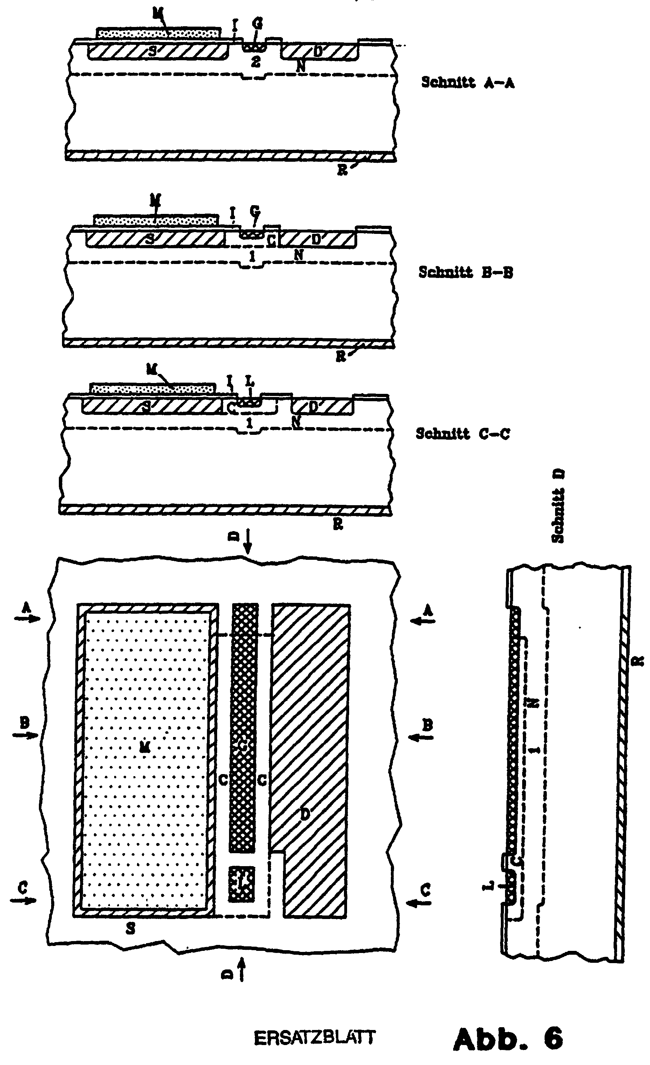

In den bisherigen Ausführungsbeispielen wurden ringförmige Strukturen gezeigt. Andere Geometrien sind natürlich auch möglich, wie z.B. rechteckige oder sechseckige, die von Vorteil sind, wenn z.B. in Bildzellendetektoren große Flächen vollständig bedeckt werden sollen. Auch nicht geschlossene Strukturen sind möglich. Ein Beispiel dafür ist in Abb. 6 gezeigt. Bei dieser Struktur sind internes (1) und externes (G) Gate miteinander verbunden (Schnitt A). Im Bereich der Rücksetzelektrode (Schnitt C) wird die Kanalimplantation (C) nicht durchgehend zwischen Source und Drain ausgeführt. Der Transistorstrom ist somit auf den zentralen Bereich (Schnitt C) beschränkt in dem die Steuerwirkung von externem und internem Gate gleichzeitig erfolgt.

In den gezeigten Ausführungsbeispielen wurden nur p-Kanal Sperrschichtfeldeffekt Transistoren (p-JFET) auf n-dotiertem Substrat gezeigt. Es ist natürlich auch möglich n-Kanal Transistoren auf p-Substrat zu verwenden. Weiterhin ist es möglich Verarmungs- oder Anreicherungs MOS Transistorstrukturen, sowie weitere Unipolartransistoren zu verwenden.

### Literaturverzeichnis

1. DE-Patent 34 27 476.6
   Us-Patent 4,885,620
2. J. Kemmer, G. Lutz: New Detector Concepts.
   Nucl. Instr. /& Meth. A 253, 365-377 (1987).
   EXPERIMENTAL CONFIRMATION OF A NEW SEMICONDUCTOR DETECTOR PRINCIPLE.
   By J. Kemmer, G. Lutz, U. Prechtel, K. Schuster, M. Sterzik, L. Struder, T. Ziemann MPI-PAE/Exp-EL-204, Jun 1989 Nucl. Instr./& Meth. A288 (1990) 92
3. SEMICONDUCTOR DRIFT CHAMBERS FOR POSITION AND ENERGY MEASUREMENTS.
   By P. Rehak, E. Gatti, A. Longoni, J. Kemmer, P. Holl, R. Klanner, G. Lutz, A. Wylie Nucl. Instrum. Methods A235 (1985) 224-234.
4. J. Kemmer, G. Lutz, E. Belau, U. Prechtel and W. Welser:
   Low Capacity Drift Diode.
   Nucl. Instr. /& Meth. A 253, 378-381, (1987).
5. L. Strueder, P. Holl, J. Kemmer, G. Lutz:
   Device modeling of fully depletable CCDs.
   Nucl. Instr. /& Meth. A 253, 386-392, (1987).
   L. Strueder, P. Holl, J. Kemmer, G. Lutz:
   Development of Fully Depletable PN CCDs for High Energy Applications.
   Nucl. Instr. /& Meth. A 257 (1987) 594-602
6. G. Lutz, et al.:
   Present and Future Semiconductor Tracking Detectors
   MPI-PAE / Exp.El. 175 April 1987
   J. Kemmer and G. Lutz:
   New structures for position sensitive semiconductor detectors
   Nucl. Instr. /& Meth. A 273 (1988) 588-598

## Patentansprüche

1. Halbleiterdetektorstruktur, bestehend aus einem Halbleiterkörper, mit
- einem in den Halbleiterkörper integrierten Unipolartransistor, der
- eine Drain,
- eine Source,
- ein Topgate,
- einen Rücksetzkontakt sowie
- eine potentialmäßig schwimmenden Schicht die mindestens ein internes Gate des Unipolartransistors bildet,
aufweist, und
- mindestens einem Kondensator, dessen erste Elektrode unmittelbar an die Source angeschlossen ist,
**gekennzeichnet durch** die Kombination folgender Merkmale:
- der Unipolartransistor ist ein horizontaler Transistor, der auf der einen ersten Hauptoberfläche aufgebracht ist und dessen Kanal parallel zu dieser Hauptoberfläche liegt,
- auf der zweiten Hauptoberfläche ist ein Rückkontakt aufgebracht, der zur Verarmung des Halbleiterkörpers von Ladungsträgern und zur Ausbildung eines Potentialberges unterhalb der ersten Hauptoberfläche dient, und
- das Potential der zweiten Elektrode des Kondensators konstant ist

2. Halbleiterdetektorstruktur nach Anspruch 1,
**dadurch gekennzeichnet, daß** der Unipolartransistor MOS Verarmungs- oder Anreicherungstransistor ist.

3. Halbleiterdetektorstruktur nach Anspruch 1,
**dadurch gekennzeichnet, daß** der Unipolartransistor ein Sperrschichtfeldeffekttransistor ist.

4. Halbleiterdetektorstruktur nach Anspruch 1, 2 oder 3,
**dadurch gekennzeichnet, daß** die Source-Dotierung des Unipolartransistors die erste Elektrode des Kondensators bildet.

5. Halbleiterdetektorstruktur nach einem der Ansprüche 1 bis 4,
**dadurch gekennzeichnet, daß** die Source über mehrere Kondensatoren an extern zugängliche Kontakte angeschlossen ist.

6. Halbleiterdetektorstruktur nach Anspruch 5,
**dadurch gekennzeichnet, daß** die zweiten Elektroden der Kondensatoren durch dotierte Gebiete in der Halbleiteroberfläche gebildet werden.

7. Halbleiterdetektorstruktur nach einem der Ansprüche 1 bis 6,
**dadurch gekennzeichnet, daß** Topgate und internes Gate miteinander elektrisch verbunden sind und gemeinsam eine potentialmäßig schwimmendes Gebiet bilden.

8. Halbleiterdetektorstruktur nach einem der Ansprüche 1 bis 7,
**dadurch gekennzeichnet, daß** die potentialmäßig schwimmende Source eine Schicht mit gegenüber dem Substratmaterial stark reduzierter Minoritatsladungsträgerlebensdauer aufweist.

9. Halbleiterdetektorstruktur nach einem der Ansprüche 1 bis 7,
**dadurch gekennzeichnet, daß** in der Nähe des Detektors eine Lichtquelle, welche die Umgebung der potentialmäßig schwimmenden Source mit gepulstes oder kontinuierliches Licht bestrahlt, angeordnet ist.

10. Halbleiterdetektorstruktur nach Anspruch 9,
**dadurch gekennzeichnet, daß** sich auf der Oberseite des Detektors eine lichtundurchlässige Schicht befindet, die in der Umgebung der potentialmäßig schwimmenden Source Öffnungen aufweist.

11. Halbleiterdetektorstruktur nach Anspruch 10,
**dadurch gekennzeichnet, daß** die Potentialbarriere für das Rücksetzen, die mittlere Dotierung der n-p-n oder p-n-p Struktur, durch die Kanaldotierung gebildet wird.

12. Halhleiterdetektorstruktur nach einem der Ansprüche 1 bis 11,
**dadurch gekennzeichnet, daß** durch matrixförmige Anordnung von Grundzellen ein Bildzellendetektor entsteht, dessen Bildzellen über Auswahlleitungen aktiviert und ausgelesen werden.

13. Halbleiterdetektorstruktur nach Anspruch 12,
**dadurch gekennzeichnet, daß** die Source eines jeweiligen Pixels **über** mehrere Kondensatoren an die mit den zweiten Elektroden der Kondensatoren verbundenen Auswahlleitungen angeschlossen sind.

14. Verwendung der Halbleiterdetektorstruktur nach einem der Ansprüche 1 bis 13,
**dadurch gekennzeichnet, daß** das Rücksetzen der potentialmäßig schwimmenden Source durch kurzzeitiges Vertauschen der Funktionen von Source und Drain durch Spannungsänderung an den Elektroden erfolgt.

15. Verwendung der Halbleiterdetektorstruktur nach einem der Ansprüche 1 bis 14,
**dadurch gekennzeichnet daß** das Rücksetzen des potentialmäßig schwimmenden internen Gates gepulst oder kontinuierlich über eine n-p-n (für Signalelektronen) oder p-n-p (für Signallöcher) Struktur, die sich in der Region zwischen Source und Gate befindet, erfolgt, wobei die Gebiete gleichen Leitungstyps das interne Gate sowie die Rücksetzelektrode bilden.

## Claims

1. Semiconductor detector structure, consisting of a semiconductor body with
- a unipolar transistor integrated in the semiconductor body and comprising
- a drain,
- a source,
- a top gate,
- a reset contact, and
- a floating-potential layer forming at least one internal gate of the unipolar transistor,
and
- at least one capacitor having a first electrode thereof connected directly to the source,
**characterized by** the combination of the following features:
- the unipolar transistor is a horizontal transistor mounted on a first main surface with its channel disposed to be parallel to said main surface,
- a rear contact is mounted on the second main surface and serves to deplete the semiconductor body of charge carriers and to form a potential wall below the first main surface, and
- the potential of the second electrode of the capacitor is constant.

2. Semiconductor detector structure according to claim 1,
**characterized in that** the unipolar transistor is an MOS depleting or enriching transistor.

3. Semiconductor detector structure according to claim 1,
**characterized in that** the unipolar transistor is a barrier layer field effect transistor.

4. Semiconductor detector structure according to claim 1, 2 or 3,
**characterized in that** the source doping of the unipolar transistor forms the first electrode of the capacitor.

5. Semiconductor detector structure according to any one of claims 1 to 4,
**characterized in that** the source is connected via a plurality of capacitors to externally accessible contacts.

6. Semiconductor detector structure according to claim 5,
**characterized in that** the second electrodes of the capacitors are formed by doped areas of the semiconductor surface.

7. Semiconductor detector structure according to any one of claims 1 to 6,
**characterized in that** the top gate and the internal gate are electrically connected to each other and jointly form an area of floating potential.

8. Semiconductor detector structure according to any one of claims 1 to 7,
**characterized in that** the floating-potential source is provided with a layer
in which the minority carrier lifetime is strongly reduced in comparison with that in the substrate material.

9. Semiconductor detector structure according to any one of claims 1 to 7,
**characterized in that** a light source which irradiates the surroundings of the floating-potential source with pulsed or continuous light is disposed in the vicinity of the detector.

10. Semiconductor detector structure according to claim 9,
**characterized in that** a layer which is impervious to light is disposed on the upper side of the detector, said layer being provided with openings in the vicinity of the floating-potential source.

11. Semiconductor detector structure according to claim 10,
**characterized in that** the potential barrier for the re-setting and the average doping of the n-p-n or the p-n-p structure is formed by the channel doping.

12. Semiconductor detector structure according to any one of claims 1 to 11,
**characterized in that** an image cell detector is formed by a matrix-like arrangement of basic cells, the image cells of said image cell detector being activated and read-out via selection lines.

13. Semiconductor detector structure according to claim 12,
**characterized in that** the source of each pixel is connected via a plurality of capacitors to the selection lines connected to the second electrodes of the capacitors.

14. Use of the semiconductor detector structure of any one of claims 1 to 13,
**characterized in that** the resetting of the floating-potential source is made by transiently interchanging the functions of source and drain by changing the voltages at the electrodes.

15. Use of the semiconductor detector structure of any one of claims 1 to 14,
**characterized in that** the resetting of the floating-potential internal gate is made in pulsed or continuous manner via an n-p-n structure (for signal electrons) or a p-n-p structure (for signal holes) located in the area between source and gate, the areas of the same conduction type forming the internal gate as well as the reset electrode.

## Revendications

1. Structure de détecteur à semi-conducteur, composée d'un élément à semi-conducteur avec
- un transistor unipolaire intégré dans l'élément à semi-conducteur et présentant
- un drain,
- une source,
- une grille supérieure,
- un contact de réarmement, ainsi que
- une couche à potentiel flottant formant au moins une grille interne du transistor unipolaire,
et
- au moins un condensateur dont la première électrode est reliée immédiatement à la source,
**caractérisée par** la combinaison des caractéristiques suivantes :
- le transistor unipolaire est un transistor horizontal qui est monté sur une première surface principale et dont le canal est parallèle à cette surface principale,
- un contact de réarmement est monté sur la deuxième surface principale et sert à appauvrir l'élément à semi-conducteur en porteurs de charge et à former une barrière de potentiel en dessous de la première surface principale, et
- le potentiel de la deuxième électrode du condensateur est constant.

2. Structure de détecteur à semi-conducteur selon la revendication 1, **caractérisée en ce que** le transistor unipolaire est un transistor MOS à appauvrissement ou à enrichissement.

3. Structure de détecteur à semi-conducteur selon la revendication 1, **caractérisée en ce que** le transistor unipolaire est un transistor à effet de champ à jonction de grille.

4. Structure de détecteur à semi-conducteur selon la revendication 1, 2 ou 3, **caractérisée en ce que** le dopage de la source du transistor unipolaire forme la première électrode du condensateur.

5. Structure de détecteur à semi-conducteur selon l'une des revendications 1 à 4, **caractérisée en ce que** la source est reliée par le biais de plusieurs condensateurs à des contacts accessibles de l'extérieur.

6. Structure de détecteur à semi-conducteur selon la revendication 5, **caractérisée en ce que** les deuxièmes électrodes des condensateurs sont formées par des zones dopées dans la surface du semi-conducteur.

7. Structure de détecteur à semi-conducteur selon l'une des revendications 1 à 6, **caractérisée en ce que** la grille supérieure et la grille interne sont reliées entre elles électriquement et forment ensemble une zone à potentiel flottant.

8. Structure de détecteur à semi-conducteur selon l'une des revendications 1 à 7, **caractérisée en ce que** la source à potentiel flottant présente une couche ayant une durée de vie des porteurs de charge minoritaires qui est fortement réduite par rapport au matériau du substrat.

9. Structure de détecteur à semi-conducteur selon l'une des revendications 1 à 7, **caractérisée en ce qu'**une source lumineuse est disposée à proximité du détecteur et expose le voisinage de la source à potentiel flottant à un rayonnement de lumière pulsée ou continue.

10. Structure de détecteur à semi-conducteur selon la revendication 9, **caractérisée en ce qu'**une couche non transparente à la lumière se trouve sur le dessus du détecteur et présente des ouvertures au voisinage de la source à potentiel flottant.

11. Structure de détecteur à semi-conducteur selon la revendication 10, **caractérisée en ce que** la barrière de potentiel pour le réarmement, le dopage du milieu de la structure n-p-n ou p-n-p, est formée par le dopage du canal.

12. Structure de détecteur à semi-conducteur selon l'une des revendications 1 à 11, **caractérisée en ce que** la disposition en forme de matrice des cellules de base donne un détecteur d'image cellulaire dont les cellules d'image sont activées et lues par le biais de lignes de sélection.

13. Structure de détecteur à semi-conducteur selon la revendication 12, **caractérisée en ce que** la source d'un pixel individuel est reliée par le biais de plusieurs condensateurs aux lignes de sélection reliées aux deuxièmes électrodes des condensateurs.

14. Utilisation de la structure de détecteur à semi-conducteur selon l'une des revendications 1 à 13, **caractérisée en ce que** le réarmement de la source à potentiel flottant se fait en permutant brièvement les fonctions de la source et du drain par le biais d'une variation de tension aux bornes des électrodes.

15. Utilisation de la structure de détecteur à semi-conducteur selon l'une des revendications 1 à 14, **caractérisée en ce que** le réarmement de la grille interne à potentiel flottant se fait de manière pulsée ou continue par le biais d'une structure n-p-n (pour les électrons de signal) ou p-n-p (pour les trous de signal) qui se trouve dans la région entre la source et la grille, les zones qui ont le même type de conduction formant la grille interne ainsi que l'électrode de réarmement.
